# EUROPEAN PATENT APPLICATION

(11) **EP 4 617 946 A1**
(43) Date of publication of application: **17.09.2025**
(21) Application number: 23888650.1
(22) Date of filing: 06.11.2023
(51) Int. Cl.: G06K 19/077, H01L 25/00, H01L 25/04, H01L 25/18

(54) **RFID LABEL AND METHOD FOR USING RFID LABEL**

(30) Priority: 07.11.2022 JP 2022178285
(71) Applicant: SATO Corporation, Tokyo 108-0023 (JP)
(72) Inventor: NITTA, Shinya, Tokyo 108-0023 (JP)
(74) Representative: Grünecker Patent- und Rechtsanwälte PartG mbB
(86) International application number: PCT/JP2023/039859
(87) International publication number: WO 2024/101302

(57) **Abstract**

An RFID label includes a heat-resistant substrate that has a first portion and a second portion divided by a base point portion intersecting a longitudinal direction and extending in a width direction, and has heat resistance; an antenna and an IC chip that are provided in the second portion; a first adhesive layer provided on the second portion; and a second adhesive layer provided on the first portion, a length of the second portion is formed to be larger than a length of the first portion in the longitudinal direction.

## Description

### TECHNICAL FIELD

The present invention relates to an RFID label and a method for using the RFID label.

### BACKGROUND ART

An RFID medium such as a label or a tag corresponding to a radio frequency identification (RFID) technique of transmitting and receiving information by non-contact communication is widely used. According to the RFID medium, it is possible not only to visually print information on the RFID medium but also to store the information in a built-in IC chip.

JP2008-299053A discloses an RFID label on which an IC chip and an antenna are mounted and that is used by being attached to an adherend.

### SUMMARY OF INVENTION

In fields such as product management and logistics, an application range of the label corresponding to the RFID technique is expanding. Accordingly, in recent years, the RFID label has been required to be used in a temperature environment higher than an ambient temperature.

Therefore, regarding the RFID label as described in JP2008-299053A, further improvement has been required in order to withstand use in a high-temperature environment at which the adherend is used.

Therefore, an object of the present invention is to increase heat resistance of an RFID label.

According to an aspect of the present invention, there is provided an RFID label that includes a heat-resistant substrate that is formed in a band shape, has a first portion and a second portion divided by a base point portion intersecting a longitudinal direction and extending in a width direction, and has heat resistance; an antenna and an IC chip connected to the antenna that are provided in the second portion; a first adhesive layer provided on the second portion; and a second adhesive layer provided on the first portion to be attached to an adherend, in which a length of the second portion in the longitudinal direction is formed to be larger than a length of the first portion in the longitudinal direction.

According to the aspect of the present invention, it is possible to improve heat resistance of the RFID label.

### BRIEF DESCRIPTION OF DRAWINGS

[FIG. 1] FIG. 1 is a plan view illustrating an RFID label according to a first embodiment of the present invention.
[FIG. 2] FIG. 2 is a cross-sectional view taken along a line II-II in FIG. 1.
[FIG. 3] FIG. 3 is a schematic view illustrating a first attaching mode of the RFID label according to the first embodiment.
[FIG. 4] FIG. 4 is a schematic view illustrating a second attaching mode of the RFID label according to the first embodiment.
[FIG. 5] FIG. 5 is a plan view illustrating an RFID label according to a second embodiment of the present invention.
[FIG. 6] FIG. 6 is a cross-sectional view taken along a line VI-VI in FIG. 5.
[FIG. 7] FIG. 7 is a schematic view illustrating a first attaching mode of the RFID label according to the second embodiment.
[FIG. 8] FIG. 8 is a schematic view illustrating a second attaching mode of the RFID label according to the second embodiment.
[FIG. 9] FIG. 9 is a cross-sectional view illustrating an RFID label as a first modification.
[FIG. 10] FIG. 10 is a cross-sectional view illustrating an RFID label as a second modification.
[FIG. 11] FIG. 11 is a cross-sectional view illustrating an RFID label as a third modification.
[FIG. 12] FIG. 12 is a cross-sectional view illustrating an RFID label as a fourth modification.
[FIG. 13] FIG. 13 is a cross-sectional view illustrating an RFID label as a fifth modification.

### DESCRIPTION OF EMBODIMENTS

Embodiments described below are not limited to the drawings described by a brief description thereof.

A first aspect of an embodiment according to the present invention relates to an RFID label that includes a heat-resistant substrate that is formed in a band shape, has a first portion and a second portion divided by a base point portion intersecting a longitudinal direction and extending in a width direction, and has heat resistance; an antenna and an IC chip connected to the antenna that are provided in the second portion; a first adhesive layer provided on the second portion; and a second adhesive layer provided on the first portion to be attached to an adherend, in which a length of the second portion in the longitudinal direction is formed to be larger than a length of the first portion in the longitudinal direction.

According to the first aspect of the embodiment of the present invention, it is possible to fold the second portion toward the first portion with the base point portion as a base point.

Since the length of the second portion in the longitudinal direction is formed to be larger than the length of the first portion in the longitudinal direction, it is possible to bend the second portion to form an arch protruding toward a side away from a surface of the adherend.

When the second portion forms an arch shape, it is possible to keep the antenna and the IC chip provided in the second portion away from the surface of the adherend. Accordingly, the antenna and the IC chip can be less likely to be affected by a surface temperature of the adherend.

Therefore, according to the first aspect of the embodiment of the present invention, it is possible to improve heat resistance of the RFID label.

A second aspect of the embodiment according to the present invention relates to the RFID label according to the first aspect in which the first adhesive layer is disposed on a first surface of the heat-resistant substrate on an end portion side of the second portion opposite to the base point portion, and the second adhesive layer is disposed on at least a part of a second surface opposite to the first surface.

According to the second aspect of the embodiment of the present invention, the heat-resistant substrate is attached to the adherend at the second adhesive layer, and an end portion of the second portion and an end portion of the first portion are overlapped and attached by the first adhesive layer, and thus the second portion can maintain the arch shape in a state in which the heat-resistant substrate is attached to the adherend.

Accordingly, it is possible to keep the antenna and the IC chip formed in the second portion away from the surface of the adherend and maintain this state.

Since the antenna and the IC chip are formed on the second surface at the second portion, the antenna and the IC chip are located outside the arch shape. Accordingly, since the first portion and the second portion are interposed between the surface of the adherend and the antenna and the IC chip, a heat shielding effect to the antenna and the IC chip is improved.

Therefore, according to the second aspect of the embodiment of the present invention, it is possible to improve the heat resistance of the RFID label.

A third aspect of the embodiment according to the present invention relates to the RFID label according to the second aspect in which the heat-resistant substrate has, at positions corresponding to a boundary portion on a base point portion side of the first adhesive layer, a pair of notches formed at both side edge portions extending in the longitudinal direction of the heat-resistant substrate.

According to the third aspect of the embodiment of the present invention, the pair of notches facilitate bending of the heat-resistant substrate at the positions corresponding to the boundary portion on the base point portion side of the first adhesive layer.

Therefore, according to the third aspect of the embodiment of the present invention, an attached portion between the first portion and the second portion by the first adhesive layer is less likely to peel off, and the arch shape of the second portion is easily maintained.

A fourth aspect of the embodiment according to the present invention relates to the RFID label according to the second aspect or the third aspect in which the heat-resistant substrate has, at a position corresponding to a boundary portion on a base point portion side of the first adhesive layer, a perforation formed over both side edge portions extending in the longitudinal direction of the heat-resistant substrate.

By the perforation in the fourth aspect of the embodiment according to the present invention, a heat-resistant substrate is more easily bent at the position corresponding to the boundary portion on the base point portion side of the first adhesive layer.

Therefore, according to the fourth aspect of the embodiment of the present invention, the effect of preventing the attached portion between the first portion and the second portion by the first adhesive layer from peeling off and the effect of maintaining the arch shape of the second portion are improved.

A fifth aspect of the embodiment according to the present invention relates to the RFID label according to any one of the second aspect to the fourth aspect that further includes a third adhesive layer disposed on the first surface of the heat-resistant substrate from the base point portion toward an inner side of the second portion.

According to the fifth aspect of the embodiment of the present invention, the heat-resistant substrate is attached to the adherend at the second adhesive layer, the end portion of the second portion and the end portion of the first portion are overlapped and attached by the first adhesive layer, and the first portion and the second portion are attached by the third adhesive layer in the vicinity of the base point portion. Accordingly, the second portion can maintain the arch shape.

A sixth aspect of the embodiment according to the present invention relates to the RFID label according to the fifth aspect in which the heat-resistant substrate has, at positions corresponding to a boundary portion opposite to the base point portion of the third adhesive layer, a pair of notches formed at both side edge portions extending in the longitudinal direction of the heat-resistant substrate.

According to the sixth aspect of the embodiment of the present invention, the pair of notches formed at the positions corresponding to the boundary portion opposite to the base point portion of the third adhesive layer can facilitate the bending of the heat-resistant substrate at the boundary portion opposite to the base point portion of the third adhesive layer.

Therefore, according to the sixth aspect of the embodiment of the present invention, an attached portion between the first portion and the second portion by the third adhesive layer is less likely to peel off, and the arch shape of the second portion is easily maintained.

A seventh aspect of the embodiment according to the present invention relates to the RFID label according to the fifth aspect or the sixth aspect in which the heat-resistant substrate has, at a position corresponding to a boundary portion opposite to the base point portion of the third adhesive layer, a perforation formed over both side edge portions extending in the longitudinal direction of the heat-resistant substrate.

According to the seventh aspect of the embodiment of the present invention, the heat-resistant substrate can be more easily bent by the perforation formed at the position corresponding to the boundary portion opposite to the base point portion of the third adhesive layer.

Therefore, according to the seventh aspect of the embodiment of the present invention, the effect of preventing the attached portion between the first portion and the second portion by the third adhesive layer from peeling off and the effect of maintaining the arch shape of the second portion are improved.

An eighth aspect of the embodiment according to the present invention relates to the RFID label according to any one of the first aspect to the seventh aspect in which the antenna and the IC chip are formed on a first surface of the heat-resistant substrate at the second portion.

According to the eighth aspect of the embodiment of the present invention, when the end portion of the second portion and the end portion of the first portion are folded at the base point portion to overlap each other, and the second portion and the first portion are attached to each other by the first adhesive layer, the second surface of the heat-resistant substrate becomes a front side of the RFID label, and the antenna and the IC chip formed on the first surface at the second portion are located inside the RFID label, and thus it is possible to protect the antenna and the IC chip.

A ninth aspect of the embodiment according to the present invention relates to the RFID label according to any one of the first aspect to the seventh aspect in which the antenna and the IC chip are formed on a second surface of the heat-resistant substrate at the second portion.

According to the ninth aspect of the embodiment of the present invention, when the end portion of the second portion and the end portion of the first portion are folded at the base point portion to overlap each other, and the second portion and the first portion are attached to each other by the first adhesive layer, the second surface of the heat-resistant substrate becomes the front side of the RFID label, and the antenna and the IC chip formed on the second surface at the second portion are located on the front side the RFID label.

Thus, since the first portion and the second portion are interposed between the surface of the adherend and the antenna and the IC chip, the heat shielding effect to the antenna and the IC chip is improved.

A tenth aspect of the embodiment according to the present invention relates to the RFID label according to any one of the first aspect to the seventh aspect in which the antenna and the IC chip are provided on an inlay substrate, and the inlay substrate is disposed on a first surface at the second portion.

According to the tenth aspect of the embodiment of the present invention, since the inlay substrate on which the antenna and the IC chip are formed is disposed on the first surface of the heat-resistant substrate, it is possible to protect the antenna and the IC chip.

Further, according to the tenth aspect of the embodiment of the present invention, the heat-resistant substrate on which the first adhesive layer and the second adhesive layer are laminated and the inlay substrate are separately produced, the inlay substrate separately produced according to the types of the antenna and the IC chip can be selected according to an application and attached to the heat-resistant substrate before the RFID label is attached to the adherend and is used, and then the RFID label can be attached to the adherend.

Therefore, according to the tenth aspect of the embodiment of the present invention, it is possible to facilitate design changes of the antenna and the IC chip.

An eleventh aspect of the embodiment according to the present invention relates to the RFID label according to any one of the first aspect to the seventh aspect in which the antenna and the IC chip are provided on an inlay substrate, and the inlay substrate is disposed on a second surface at the second portion.

According to the eleventh aspect of the embodiment of the present invention, when the end portion of the second portion and the end portion of the first portion are folded at the base point portion to overlap each other, and the second portion and the first portion are attached to each other by the first adhesive layer, the second surface of the heat-resistant substrate on which the inlay substrate is disposed becomes the front side of the RFID label.

Thus, since the first portion, the second portion, and the inlay substrate are interposed between the surface of the adherend and the antenna and the IC chip, the heat shielding effect to the antenna and the IC chip is improved.

A twelfth aspect of the embodiment according to the present invention relates to the RFID label according to any one of the first aspect to the eleventh aspect in which the first adhesive layer has heat resistance.

According to the twelfth aspect of the embodiment of the present invention, since the first adhesive layer has the heat resistance, even in a high-temperature environment in which the adherend is used, a bonding strength when the end portion of the second portion and the end portion of the first portion are folded at the base point portion to overlap each other, and the second portion and the first portion are attached to each other by the first adhesive layer can be increased.

A thirteenth aspect of the embodiment according to the present invention relates to a method for using an RFID label, the RFID label includes a heat-resistant substrate that is formed in a band shape, has a first portion and a second portion divided by a base point portion intersecting a longitudinal direction and extending in a width direction, and has heat resistance, an antenna and an IC chip connected to the antenna that are provided in the second portion, a first adhesive layer provided on the second portion, and a second adhesive layer provided on the first portion to be attached to an adherend and having heat resistance, a length of the second portion in the longitudinal direction is larger than a length of the first portion in the longitudinal direction, the method includes: folding at the base point portion, overlapping an end portion of the second portion and an end portion of the first portion, and bonding the second portion and the first portion by using the first adhesive layer.

According to the thirteenth aspect of the embodiment of the present invention, it is possible to fold the second portion of the RFID label toward the first portion with the base point portion as the base point.

Since the length of the second portion in the longitudinal direction is formed to be larger than the length of the first portion in the longitudinal direction, it is possible to bend the second portion to form the arch protruding toward the side away from the surface of the adherend.

When the second portion forms the arch shape, it is possible to keep the antenna and the IC chip provided in the second portion away from the surface of the adherend. Accordingly, the antenna and the IC chip can be less likely to be affected by the surface temperature of the adherend.

Therefore, according to the thirteenth aspect of the embodiment of the present invention, it is possible to improve the heat resistance of the RFID label.

A fourteenth aspect of the embodiment according to the present invention relates to a method for using an RFID label, the RFID label includes a heat-resistant substrate that is formed in a band shape, has a first portion and a second portion divided by a base point portion intersecting a longitudinal direction and extending in a width direction, and has heat resistance, an antenna and an IC chip connected to the antenna that are provided in the second portion, a first adhesive layer provided on the second portion, and a second adhesive layer provided on the first portion to be attached to an adherend and having heat resistance, a length of the second portion in the longitudinal direction is larger than a length of the first portion in the longitudinal direction, the method includes: folding at the base point portion, and attaching the first adhesive layer provided on the second portion and the second adhesive layer provided on the first portion to the same plane of the adherend in the vicinity of an end portion of the first portion.

According to the fourteenth aspect of the embodiment of the present invention, it is possible to fold the second portion of the RFID label toward the first portion with the base point portion as the base point.

Since the length of the second portion in the longitudinal direction is formed to be larger than the length of the first portion in the longitudinal direction, it is possible to bend the second portion to form the arch protruding toward the side away from the surface of the adherend.

When the second portion forms the arch shape, it is possible to keep the antenna and the IC chip provided in the second portion away from the surface of the adherend. Accordingly, the antenna and the IC chip can be less likely to be affected by the surface temperature of the adherend.

Therefore, according to the fourteenth aspect of the embodiment of the present invention, it is possible to improve the heat resistance of the RFID label.

### [First Embodiment]

### <Configuration of RFID Label>

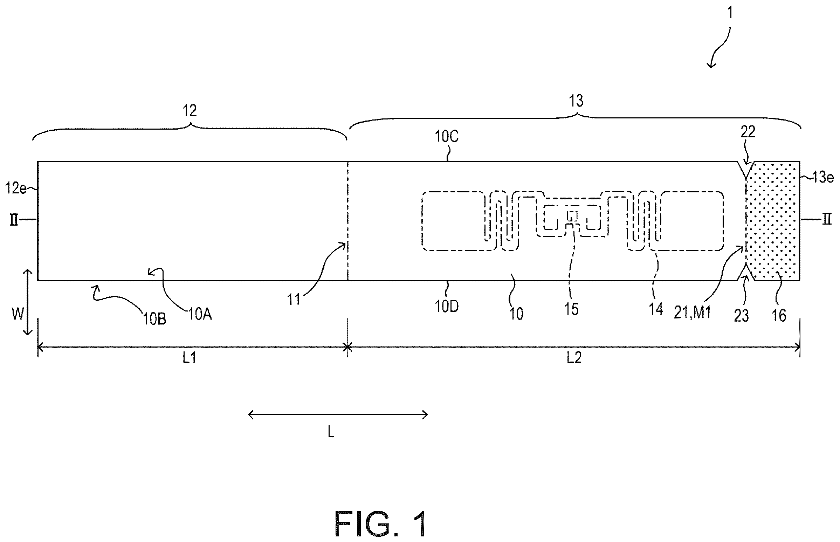

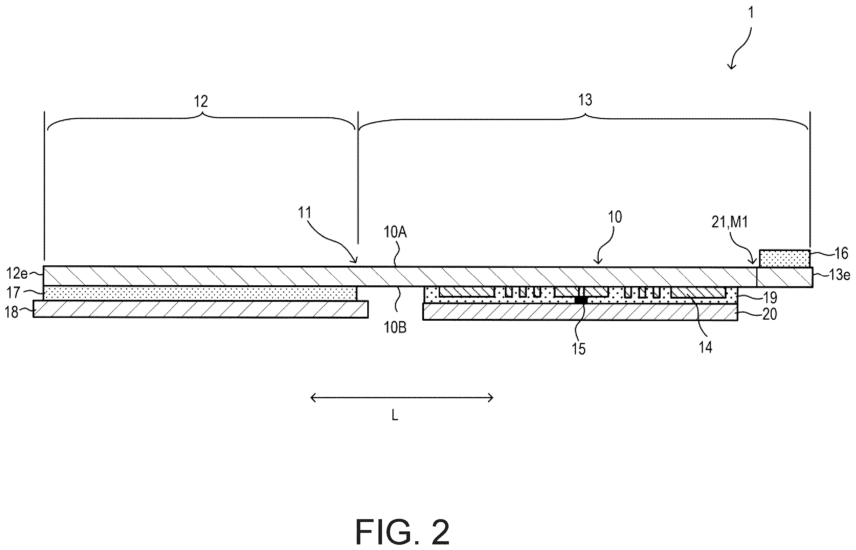

FIG. 1 is a plan view illustrating an RFID label 1 according to a first embodiment of the present invention, and FIG. 2 is a cross-sectional view taken along a line II-II in FIG. 1.

The RFID label 1 includes a heat-resistant substrate 10 having heat resistance. The heat-resistant substrate 10 is formed in a band shape, and includes a first portion 12 and a second portion 13 that are divided by a base point portion 11 extending in a width direction (the W direction in FIG. 1) intersecting a longitudinal direction (the L direction in FIG. 1).

A length L2 of the second portion 13 in the longitudinal direction is formed to be larger than a length L1 of the first portion 12 in the longitudinal direction. That is, a relation of L2 > L1 is set.

As examples of the heat-resistant substrate 10, a single resin film such as polyethylene terephthalate, polypropylene, polyethylene naphthalate, polyether ether ketone, polyimide, polyamideimide, polyphenylene sulfide, or a fluororesin sheet, or a multilayer film formed by laminating a plurality of resin films among these resin films can be used.

Among these resin materials, polyethylene terephthalate or polyethylene naphthalate can be preferably used because desired heat resistance and desired heat insulation can be obtained in an application temperature range and cost-effectiveness is high. In addition, in terms of the heat resistance and the cost-effectiveness, a paper substrate such as high-quality paper, medium-quality paper, or coated paper formed by using the high-quality paper and medium-quality paper may be used in addition to the above resin film.

A first adhesive layer 16 and a second adhesive layer 17 are disposed on the heat-resistant substrate 10. The first adhesive layer 16 is disposed on a first surface 10A of the heat-resistant substrate 10.

The first adhesive layer 16 is disposed on the first surface 10A of the heat-resistant substrate 10 on an end portion 13e side of the second portion 13 opposite to the base point portion 11.

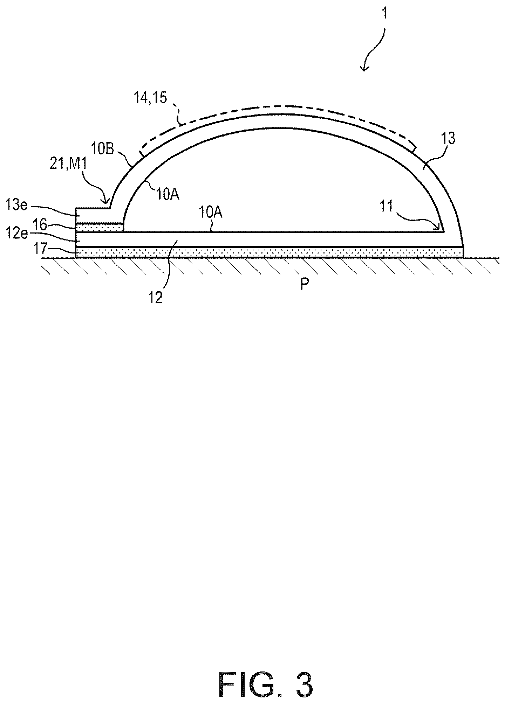

The second adhesive layer 17 is disposed on the first portion 12. The second adhesive layer 17 is disposed on a second surface 10B, which is a surface opposite to the first surface 10A of the heat-resistant substrate 10, at the first portion 12. The second adhesive layer 17 is an adhesive layer to be attached to an adherend P (see FIG. 3).

An adhesive forming the first adhesive layer 16 and the second adhesive layer 17 preferably has heat resistance, and as an example thereof, an acryl-based adhesive or a silicon-based adhesive can be used according to a temperature range for use. The first adhesive layer 16 and the second adhesive layer 17 can be formed on the heat-resistant substrate 10 by coating, and further, an adhesive tape obtained by laminating a plurality of small-molecular acrylic adhesive layers, which are formed of acrylic resins having different molecular weights, can be used as the acryl-based adhesive.

The first adhesive layer 16 and the second adhesive layer 17 may be adhesive surfaces formed by attaching a thin film fastening tape, which has acryl-based adhesive layers formed on both surfaces thereof, to the heat-resistant substrate 10. The thin film fastening tape is excellent in conformability and repulsion resistance to an adherend, and can maintain excellent adhesive strength even in a high-temperature environment. The thin film fastening tape is preferably thin and highly tacky.

A separator 18 is attached to the second adhesive layer 17. Since the separator 18 has been subjected to a release treatment, the separator 18 can be released from the second adhesive layer 17. The second adhesive layer 17 can be attached to the adherend without losing tackiness thereof even after the separator 18 is released.

An antenna 14 and an IC chip 15 connected to the antenna 14 are provided in the second portion 13. In the second portion 13, the antenna 14 and the IC chip 15 are provided on the second surface 10B of the heat-resistant substrate 10.

As an example, the antenna 14 can be formed of a conductive sheet containing a conductive material. The conductive material is applicable as long as it is a conductive material generally used for forming an antenna.

As examples of the conductive material, metals can be used. Among the metals, preferably, copper and aluminum are used. From the viewpoint of saving production cost, an aluminum foil is preferably used as the conductive sheet.

The thickness of this metal foil is preferably 3 µm or more and 25 µm or less from the viewpoint of the total thickness of the RFID label 1 and the production cost. More preferably, the thickness is 20 µm.

The antenna 14 can be formed of the aluminum foil having a predetermined shape. Alternatively, the antenna 14 can be formed by depositing aluminum on the heat-resistant substrate 10.

The antenna 14 includes a meander portion and a capacitor hat portion, and constitutes a dipole antenna extending in the L direction. The IC chip 15 is connected to a central portion of the antenna 14.

The IC chip 15 is an IC chip conforming to a radio frequency identification (RFID) specification.

As illustrated in FIG. 1, the heat-resistant substrate 10 has, at positions corresponding to a boundary portion 21 on a base point portion 11 side of the first adhesive layer 16, a pair of notches 22, 23 formed at both side edge portions 10C, 10D extending in the longitudinal direction of the heat-resistant substrate 10.

The pair of notches 22, 23 facilitate bending of the heat-resistant substrate 10 at the positions corresponding to the boundary portion 21 on the base point portion 11 side of the first adhesive layer 16.

The heat-resistant substrate 10 is formed with a perforation M1 at a position corresponding to the boundary portion 21 on the base point portion 11 side of the first adhesive layer 16. The perforation M1 is formed over both the side edge portions 10C, 10D extending in the longitudinal direction of the heat-resistant substrate 10. That is, the perforation M1 is formed over the width direction W of the heat-resistant substrate 10.

Both the perforation M1 and the pair of notches 22, 23 facilitate the bending of the heat-resistant substrate 10 at the positions corresponding to the boundary portion 21 on the base point portion 11 side of the first adhesive layer 16.

In the second portion 13, a surface substrate 20 is attached by an adhesive layer 19 to the second surface 10B of the heat-resistant substrate 10 on which the antenna 14 and the IC chip 15 are provided. In the present embodiment, the antenna 14 and the IC chip 15 are covered with the surface substrate 20 at the second portion 13.

The RFID label 1 having the above configuration can be folded at the base point portion 11 such that an end portion 13e of the second portion 13 and an end portion 12e of the first portion 12 overlap each other.

### <Attaching Modes and Advantages of RFID Label>

Next, advantages achieved by the present embodiment will be described together with a first attaching mode of the RFID label 1 having the above configuration.

FIG. 3 is a schematic view illustrating the first attaching mode of the RFID label 1 according to the first embodiment.

As illustrated in FIG. 3, the RFID label 1 can be attached to the adherend P by the second adhesive layer 17, and the second portion 13 can be folded toward the first portion 12 with the base point portion 11 as a base point.

Since the length L2 of the second portion 13 in the longitudinal direction is formed to be larger than the length L1 of the first portion 12 in the longitudinal direction, it is possible to bend the second portion 13 to form an arch protruding toward a side away from a surface of the adherend.

Therefore, a space is formed between the first portion 12 attached to the adherend P and the second portion 13 with the first portion 12 as a base.

The end portion 13e of the second portion 13 and the end portion 12e of the first portion 12 are overlapped and attached by the first adhesive layer 16, and thus the second portion 13 can maintain an arch shape.

When the second portion 13 forms the arch shape, it is possible to keep the antenna 14 and the IC chip 15 away from the surface of the adherend. Accordingly, the antenna 14 and the IC chip 15 are less likely to be affected by the surface temperature of the adherend.

Therefore, it is possible to improve heat resistance of the RFID label 1.

Further, at this time, the antenna 14 and the IC chip 15 provided on the second surface 10B at the second portion 13 are located outside the arch shape as indicated by a virtual line in FIG. 3.

In this way, since the first portion 12 and the second portion 13 are interposed between the surface of the adherend P and the antenna 14 and the IC chip 15, a heat shielding effect to the antenna 14 and the IC chip 15 is improved.

Therefore, it is possible to improve the heat resistance of the RFID label 1.

In addition, in the RFID label 1, the heat-resistant substrate 10 is formed with the pair of notches 22, 23 at the positions corresponding to the boundary portion 21 on the base point portion 11 side of the first adhesive layer 16. The pair of notches 22, 23 facilitate the bending of the heat-resistant substrate 10 at the positions corresponding to the boundary portion 21 on the base point portion 11 side of the first adhesive layer 16.

Therefore, an attached portion between the first portion 12 and the second portion 13 by the first adhesive layer 16 is less likely to peel off, and the arch shape of the second portion 13 is easily maintained.

In addition, the heat-resistant substrate 10 is more easily bent by the perforation M1 formed at the position corresponding to the boundary portion 21 on the base point portion 11 side of the first adhesive layer 16. Therefore, the effect of preventing the attached portion between the first portion 12 and the second portion 13 by the first adhesive layer 16 from peeling off and the effect of maintaining the arch shape of the second portion 13 are improved.

Next, the advantages achieved by the present embodiment will be described together with a second attaching mode of the RFID label 1 having the above configuration.

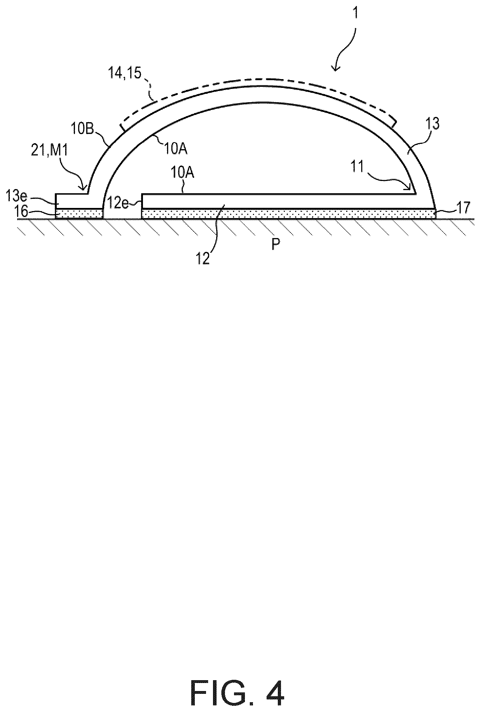

FIG. 4 is a schematic view illustrating the second attaching mode of the RFID label 1 according to the first embodiment.

As illustrated in FIG. 4, in the RFID label 1, the second adhesive layer 17 can be attached to the adherend P, and the first adhesive layer 16 formed on the second portion 13 folded with the base point portion 11 as the base point can be directly attached to the adherend P.

Since the length L2 of the second portion 13 in the longitudinal direction is formed to be larger than the length L1 of the first portion 12 in the longitudinal direction, it is possible to bend the second portion 13 to form the arch protruding toward the side away from the surface of the adherend by attaching the first adhesive layer 16 in the vicinity of the end portion 12e of the first portion 12. Therefore, the space is formed between the first portion 12 attached to the adherend P and the second portion 13.

At this time, the antenna 14 and the IC chip 15 provided on the second surface 10B at the second portion 13 are located outside the arch shape as indicated by a virtual line in FIG. 4.

In this way, since the first portion 12 and the second portion 13 are interposed between the surface of the adherend P and the antenna 14 and the IC chip 15, the heat shielding effect to the antenna 14 and the IC chip 15 is improved.

Therefore, it is possible to improve the heat resistance of the RFID label 1.

### [Second Embodiment]

### <Configuration of RFID Label>

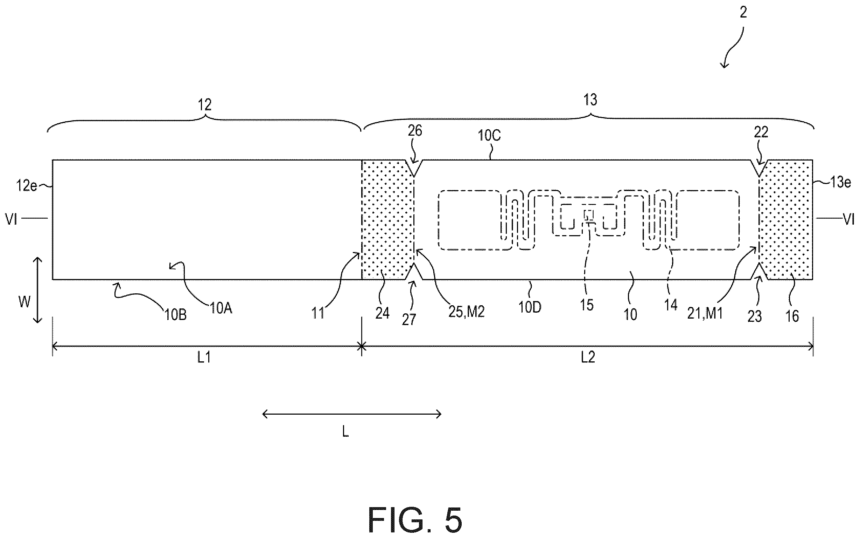

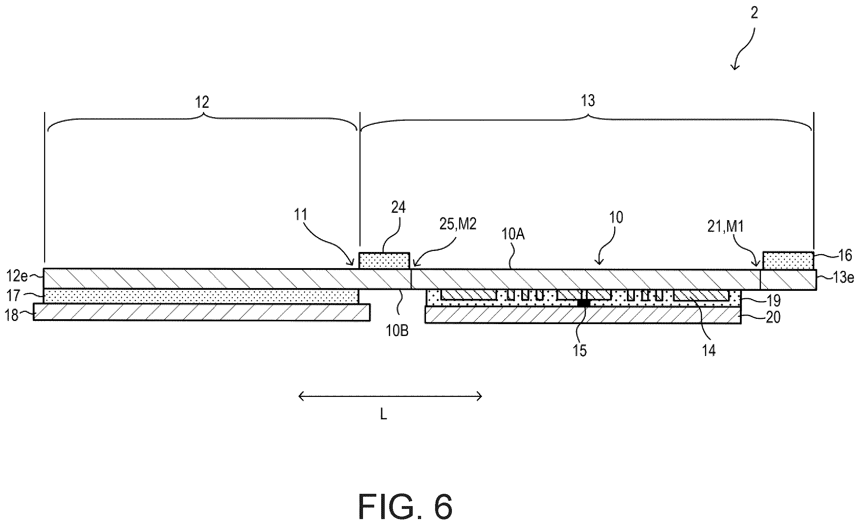

FIG. 5 is a plan view illustrating an RFID label 2 according to a second embodiment of the present invention, and FIG. 6 is a cross-sectional view taken along a line VI-VI in FIG. 5.

In the second embodiment, components having the same advantages as those of the first embodiment are denoted by the same reference numerals, and detailed description thereof will be omitted.

The RFID label 2 according to the second embodiment has a third adhesive layer 24 on the first surface 10A of the heat-resistant substrate 10. The third adhesive layer 24 is disposed on the first surface 10A of the heat-resistant substrate 10 from the base point portion 11 toward an inner side of the second portion 13 in the longitudinal direction (the L direction).

The heat-resistant substrate 10 has, at positions corresponding to a boundary portion 25 opposite to the base point portion 11 of the third adhesive layer 24, a pair of notches 26, 27 formed at both side edge portions (the side edge portions 10C, 10D) extending in the longitudinal direction of the heat-resistant substrate 10.

The pair of notches 26, 27 facilitate the bending of the heat-resistant substrate 10 at the positions corresponding to the boundary portion 25 opposite to the base point portion 11 of the third adhesive layer 24.

In addition, the heat-resistant substrate 10 is formed with a perforation M2 at a position corresponding to the boundary portion 25 opposite to the base point portion 11 of the third adhesive layer 24. The perforation M2 is formed over both the side edge portions 10C, 10D extending in the longitudinal direction of the heat-resistant substrate 10. That is, the perforation M2 is formed over the width direction W of the heat-resistant substrate 10.

Both the perforation M2 and the pair of notches 26, 27 facilitate the bending of the heat-resistant substrate 10 at the positions corresponding to the boundary portion 25 opposite to the base point portion 11 of the third adhesive layer 24.

### <Attaching Modes and Advantages of RFID Label>

Next, advantages achieved by the present embodiment will be described together with a first attaching mode of the RFID label 2 having the above configuration.

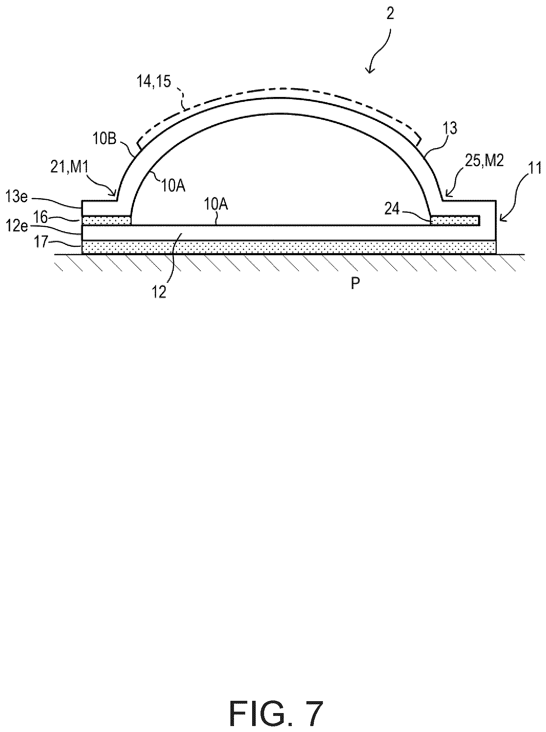

FIG. 7 is a schematic view illustrating the first attaching mode of the RFID label 2 according to the second embodiment.

As illustrated in FIG. 7, the RFID label 2 can be attached to the adherend P by the second adhesive layer 17, and the second portion 13 can be folded toward the first portion 12 with the base point portion 11 as the base point.

Since the length L2 of the second portion 13 in the longitudinal direction is formed to be larger than the length L1 of the first portion 12 in the longitudinal direction, it is possible to bend the second portion 13 to form the arch protruding toward the side away from the surface of the adherend.

Therefore, the space is formed between the first portion 12 attached to the adherend P and the second portion 13 with the first portion 12 as the base.

In the RFID label 2 according to the second embodiment, the end portion 13e of the second portion 13 and the end portion 12e of the first portion 12 are overlapped and attached by the first adhesive layer 16, and the first portion 12 and the second portion 13 are attached by the third adhesive layer 24 in the vicinity of the base point portion 11. Accordingly, the second portion 13 can maintain the arch shape.

When the second portion 13 forms the arch shape, it is possible to keep the antenna 14 and the IC chip 15 away from the surface of the adherend. Accordingly, the antenna 14 and the IC chip 15 are less likely to be affected by the surface temperature of the adherend.

Therefore, it is possible to improve the heat resistance of the RFID label 2.

Further, at this time, the antenna 14 and the IC chip 15 provided on the second surface 10B at the second portion 13 are located outside the arch shape as indicated by a virtual line in FIG. 7.

In this way, since the first portion 12 and the second portion 13 are interposed between the surface of the adherend P and the antenna 14 and the IC chip 15, the heat shielding effect to the antenna 14 and the IC chip 15 is improved.

Therefore, it is possible to improve the heat resistance of the RFID label 2.

In addition, in the RFID label 2, the heat-resistant substrate 10 is formed with the pair of notches 26, 27 at the positions corresponding to the boundary portion 25 opposite to the base point portion 11 of the third adhesive layer 24 in addition to the pair of notches 22, 23 formed at the positions corresponding to the boundary portion 21 on the base point portion 11 side of the first adhesive layer 16.

The notches 22, 23 facilitate the bending of the heat-resistant substrate 10 at the positions corresponding to the boundary portion 21 on the base point portion 11 side of the first adhesive layer 16. In addition, the notches 26, 27 also facilitate the bending at the boundary portion 25 opposite to the base point portion 11 of the third adhesive layer 24.

Therefore, both the attached portion between the first portion 12 and the second portion 13 by the first adhesive layer 16 and an attached portion between the first portion 12 and the second portion 13 by the third adhesive layer 24 are less likely to peel off, and the arch shape of the second portion 13 is easily maintained.

In addition, the heat-resistant substrate 10 is formed with the perforation M2 at the position corresponding to the boundary portion 25 opposite to the base point portion 11 of the third adhesive layer 24 in addition to the perforation M1 formed at the position corresponding to the boundary portion 21 on the base point portion 11 side of the first adhesive layer 16. Therefore, the heat-resistant substrate 10 is more easily bent by the perforations M1, M2.

Therefore, the effect of preventing the attached portion between the first portion 12 and the second portion 13 by the first adhesive layer 16 and the attached portion between the first portion 12 and the second portion 13 by the third adhesive layer 24 from peeling off and the effect of maintaining the arch shape of the second portion 13 are improved.

Next, the advantages achieved by the present embodiment will be described together with a second attaching mode of the RFID label 2 having the above configuration.

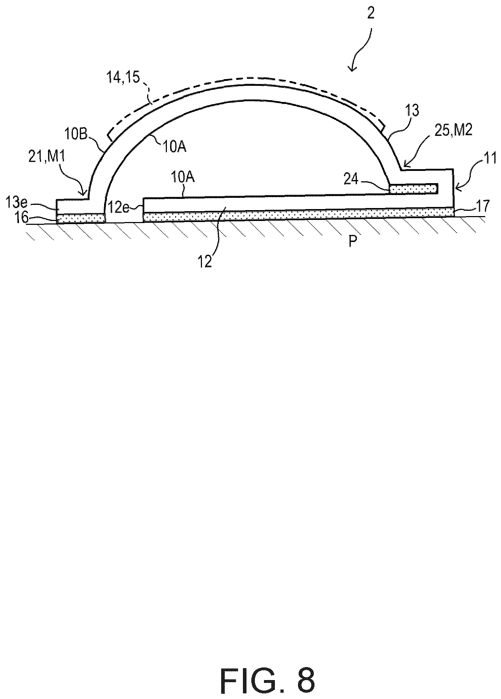

FIG. 8 is a schematic view illustrating the second attaching mode of the RFID label 2 according to the second embodiment.

As illustrated in FIG. 8, in the RFID label 2, the second adhesive layer 17 can be attached to the adherend P, and the first adhesive layer 16 formed on the second portion 13 folded with the base point portion 11 as the base point can be directly attached to the adherend P.

Since the length L2 of the second portion 13 in the longitudinal direction is formed to be larger than the length L1 of the first portion 12 in the longitudinal direction, it is possible to bend the second portion 13 to form the arch protruding toward the side away from the surface of the adherend by attaching the first adhesive layer 16 in the vicinity of the end portion 12e of the first portion 12. Therefore, the space is formed between the first portion 12 attached to the adherend P and the second portion 13.

At this time, the antenna 14 and the IC chip 15 provided on the second surface 10B at the second portion 13 are located outside the arch shape as indicated by a virtual line in FIG. 8.

In this way, since the first portion 12 and the second portion 13 are interposed between the surface of the adherend P and the antenna 14 and the IC chip 15, the heat shielding effect to the antenna 14 and the IC chip 15 is improved.

Therefore, it is possible to improve the heat resistance of the RFID label 2.

Further, in the RFID label 2 according to the second embodiment, the first adhesive layer 16 is attached in the vicinity of the end portion 12e of the first portion 12, and the first portion 12 and the second portion 13 are attached to each other by the third adhesive layer 24 in the vicinity of the base point portion 11. Accordingly, the second portion 13 can more stably maintain the arch shape.

### [Modifications]

Next, modifications of the RFID label will be described. In the following modifications, components having the same advantages as those of the first embodiment are denoted by the same reference numerals, and detailed description thereof will be omitted.

### <First Modification>

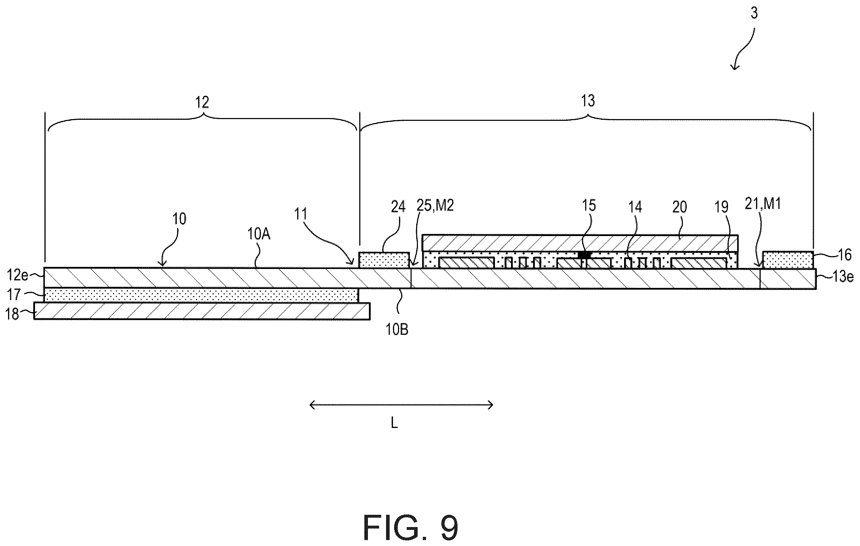

FIG. 9 is a cross-sectional view illustrating an RFID label 3 as a first modification.

As illustrated in FIG. 9, in the RFID label 3, the antenna 14 and the IC chip 15 are provided on the first surface 10A of the heat-resistant substrate 10 at the second portion 13.

The surface substrate 20 is attached by the adhesive layer 19 to the first surface 10A of the heat-resistant substrate 10 on which the antenna 14 and the IC chip 15 are provided.

In the RFID label 3 having the above configuration, when the end portion 13e of the second portion 13 and the end portion 12e of the first portion 12 are folded at the base point portion 11 to overlap each other, and the second portion 13 and the first portion 12 are attached to each other by the first adhesive layer 16, the second surface 10B of the heat-resistant substrate 10 becomes a front side of the RFID label 3, and the antenna 14 and the IC chip 15 provided on the first surface 10A of the heat-resistant substrate 10 at the second portion 13 are located inside the RFID label 3, and thus it is possible to protect the antenna 14 and the IC chip 15.

Further, since the antenna 14 and the IC chip 15 provided on the first surface 10A of the heat-resistant substrate 10 at the second portion 13 are covered with the surface substrate 20, the first portion 12 and the surface substrate 20 are interposed between the adherend P and the antenna 14 and the IC chip 15. Therefore, the heat shielding effect to the antenna 14 and the IC chip 15 is improved.

### <Second Modification>

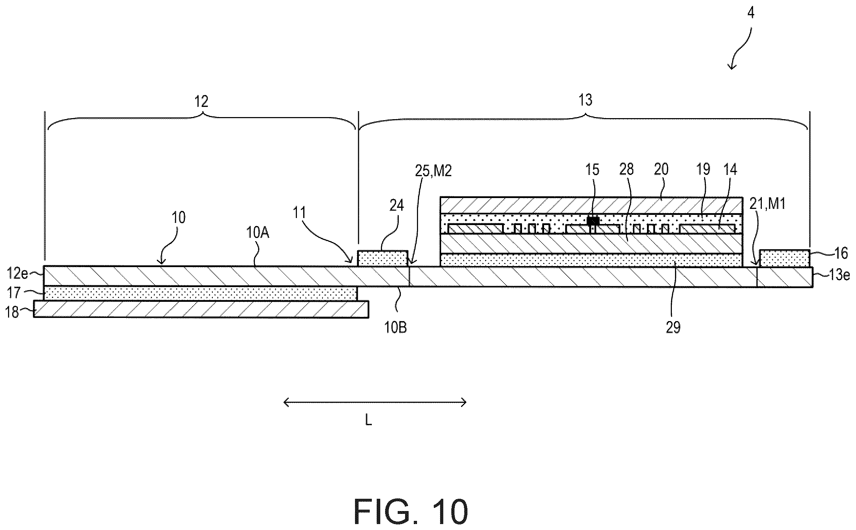

FIG. 10 is a cross-sectional view illustrating an RFID label 4 as a second modification.

As illustrated in FIG. 10, in the RFID label 4, the antenna 14 and the IC chip 15 are provided on an inlay substrate 28.

In the present embodiment, as a material applicable as the inlay substrate 28, papers such as high-quality paper and coated paper, a single resin film such as polyvinyl chloride, polyethylene terephthalate, polypropylene, polyethylene, or polyethylene naphthalate, or a multilayer film formed by laminating a plurality of resin films among these resin films can be used.

The thickness of the inlay substrate 28 is preferably 25 µm or more and 300 µm or less. When paper is used as the substrate, in the above range, the thickness thereof can be set to 50 µm or more and 260 µm or less, and is preferably 80 µm in general. Further, when a resin film is used as the substrate, in the above range, the thickness thereof can be set to 25 µm or more and 200 µm or less. Among the above, it is possible to appropriately select the material according to an application.

The surface substrate 20 is attached by the adhesive layer 19 to a surface of the inlay substrate 28 on which the antenna 14 and the IC chip 15 are provided.

The inlay substrate 28 is attached to the first surface 10A of the heat-resistant substrate 10 by an adhesive layer 29 at the second portion 13.

In the RFID label 4, the antenna 14 and the IC chip 15 are provided on the inlay substrate 28, a surface of the inlay substrate 28 opposite to the surface on which the antenna 14 and the IC chip 15 are provided faces the first surface 10A of the heat-resistant substrate 10, and is attached to the second portion 13 of the heat-resistant substrate 10 by the adhesive layer 29.

Since the inlay substrate 28 on which the antenna 14 and the IC chip 15 are provided is disposed on the first surface 10A of the heat-resistant substrate 10, it is possible to protect the antenna 14 and the IC chip 15.

Further, according to the RFID label 4 of the second modification, the heat-resistant substrate 10 on which the first adhesive layer 16, the second adhesive layer 17, and the third adhesive layer 24 are laminated, and the inlay substrate 28 can be separately produced.

Therefore, the inlay substrate 28 separately produced according to the types of the antenna 14 and the IC chip 15 can be selected according to an application and attached to the heat-resistant substrate 10 before the RFID label 4 is attached to the adherend P and is used, and then the RFID label 4 can be attached to the adherend P.

Therefore, it is possible to facilitate design changes of the antenna 14 and the IC chip 15.

### <Third Modification>

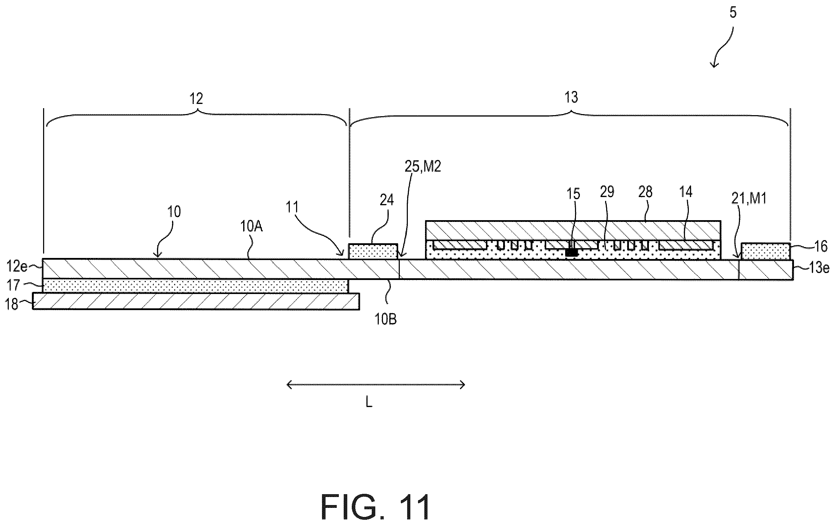

FIG. 11 is a cross-sectional view illustrating an RFID label 5 as a third modification.

As illustrated in FIG. 11, in the RFID label 5, the antenna 14 and the IC chip 15 are provided on the inlay substrate 28. The surface of the inlay substrate 28 on which the antenna 14 and the IC chip 15 are provided faces the heat-resistant substrate 10, and is attached to the second portion 13 of the heat-resistant substrate 10 by the adhesive layer 29.

In the RFID label 5, the antenna 14 and the IC chip 15 are provided on the inlay substrate 28, and the inlay substrate 28 is attached to the first surface 10A of the heat-resistant substrate 10 by the adhesive layer 29.

Since the inlay substrate 28 on which the antenna 14 and the IC chip 15 are provided is disposed on the first surface 10A of the heat-resistant substrate 10, it is possible to protect the antenna 14 and the IC chip 15.

In addition, in the RFID label 5, since the surface of the inlay substrate 28 on which the antenna 14 and the IC chip 15 are provided faces the heat-resistant substrate 10, and is attached to the second portion 13 of the heat-resistant substrate 10 by the adhesive layer 29, the first portion 12 and the inlay substrate 28 are interposed between the adherend P and the antenna 14 and the IC chip 15. Therefore, the heat shielding effect to the antenna 14 and the IC chip 15 is improved.

Further, according to the RFID label 5 of the third modification, the heat-resistant substrate 10 on which the first adhesive layer 16, the second adhesive layer 17, and the third adhesive layer 24 are laminated, and the inlay substrate 28 can be separately produced.

Therefore, the inlay substrate 28 separately produced according to the types of the antenna 14 and the IC chip 15 can be selected according to an application and attached to the heat-resistant substrate 10 before the RFID label 5 is attached to the adherend P and is used, and then the RFID label 5 can be attached to the adherend P.

Therefore, it is possible to facilitate the design changes of the antenna 14 and the IC chip 15.

### <Fourth Modification>

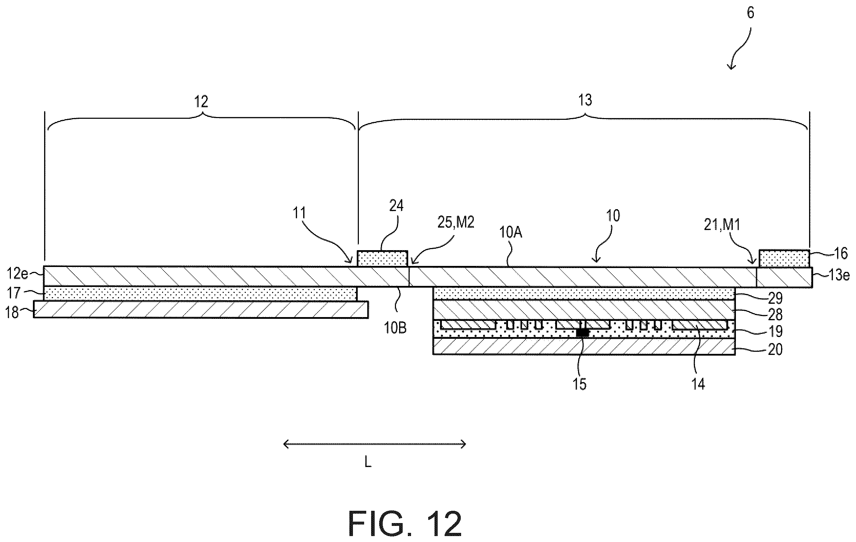

FIG. 12 is a cross-sectional view illustrating an RFID label 6 as a fourth modification.

As illustrated in FIG. 12, in the RFID label 6, the antenna 14 and the IC chip 15 are provided on the inlay substrate 28. The surface substrate 20 is attached by the adhesive layer 19 to the surface of the inlay substrate 28 on which the antenna 14 and the IC chip 15 are provided.

Since the inlay substrate 28 on which the antenna 14 and the IC chip 15 are provided is disposed on the second surface 10B of the heat-resistant substrate 10, when the end portion 13e of the second portion 13 and the end portion 12e of the first portion 12 are folded at the base point portion 11 to overlap each other, and the second portion 13 and the first portion 12 are attached to each other by the first adhesive layer 16, the second surface 10B of the heat-resistant substrate 10 on which the inlay substrate 28 is disposed becomes a front side of the RFID label 6.

Therefore, since the first portion 12, the second portion 13, and the inlay substrate 28 are interposed between the surface of the adherend P and the antenna 14 and the IC chip 15, the heat shielding effect to the antenna 14 and the IC chip 15 is improved.

### <Fifth Modification>

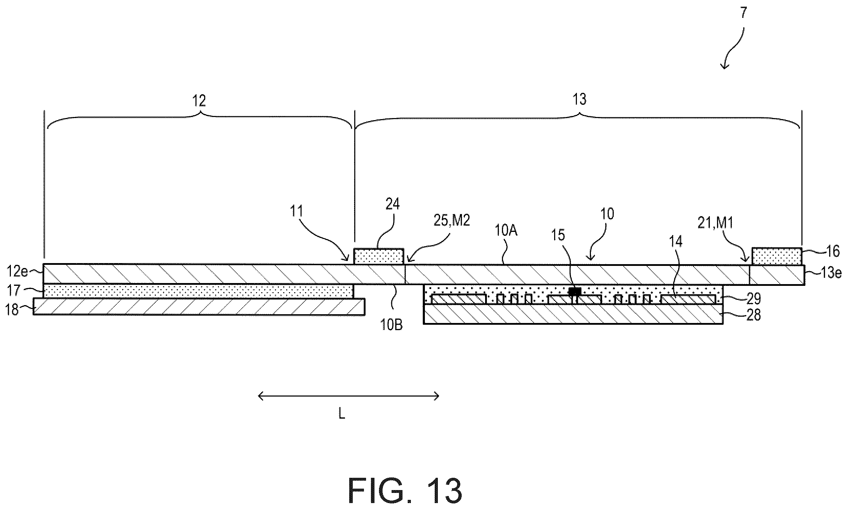

FIG. 13 is a cross-sectional view illustrating an RFID label 7 as a fifth modification.

As illustrated in FIG. 13, in the RFID label 7, the antenna 14 and the IC chip 15 are provided on the inlay substrate 28. The surface of the inlay substrate 28 on which the antenna 14 and the IC chip 15 are provided faces the heat-resistant substrate 10, and is attached to the second surface 10B of the heat-resistant substrate 10 by the adhesive layer 29 at the second portion 13.

Since the inlay substrate 28 on which the antenna 14 and the IC chip 15 are provided is disposed on the second surface 10B of the heat-resistant substrate 10, when the end portion 13e of the second portion 13 and the end portion 12e of the first portion 12 are folded at the base point portion 11 to overlap each other, and the second portion 13 and the first portion 12 are attached to each other by the first adhesive layer 16, the second surface 10B of the heat-resistant substrate 10 on which the inlay substrate 28 is disposed becomes a front side of the RFID label 6.

Therefore, since the first portion 12 and the second portion 13 are interposed between the surface of the adherend P and the antenna 14 and the IC chip 15, the heat shielding effect to the antenna 14 and the IC chip 15 is improved.

The above RFID labels 3, 4, 5, 6, and 7 can be attached to the adherend P in any of the first attaching modes and the second attaching modes described with reference to FIGS. 3, 4, 7, and 8.

### [Other Embodiments]

Although the embodiments of the present invention have been described above, the above embodiments are merely a part of application examples of the present invention, and are not intended to limit the technical scope of the present invention to the specific configurations of the above embodiments.

The shape of the antenna 14 illustrated as the embodiments and modifications is not limited to the illustrated shape. The shape can be appropriately changed according to an RFID communication standard to be applied.

The shape of the notches 22, 23, 26, and 27 illustrated in FIGS. 1 and 5 is not limited to the illustrated shape. Any shape may be applied as long as the heat-resistant substrate 10 is easily bent, and for example, rectangular notches, cut lines, and the like may be used in addition to triangular notches.

In the present embodiment, the perforations M1, M2 are respectively formed at the boundary portions 21, 25, but the number of continuous portions (uncut portions) and penetrating portions (cut portions) at the perforations is free.

In the present embodiment, only one pair of the pair of notches 22, 23 and the pair of notches 26, 27 may be formed. Further, the notches 22, 23, 26, and 27 may not be provided.

In the present embodiment, only one of the perforations M1, M2 may be formed. Further, the perforations M1, M2 may not be provided.

The perforations M1, M2 are not intended to facilitate cutting of the heat-resistant substrate 10, but are guides for facilitating the bending thereof. Therefore, in addition to the perforation having the continuous portion (the uncut portion) and the penetrating portion (the cut portion), for example, a so-called half-cut process of cutting the heat-resistant substrate 10 to a predetermined depth in a thickness direction while leaving a continuous portion may be performed.

In the RFID label 1 according to the first embodiment, the second adhesive layer 17 illustrated in FIG. 2 does not need to be disposed over the entire second surface 10B, which is the surface opposite to the first surface 10A of the heat-resistant substrate 10, at the first portion 12, and may be disposed on at least a part thereof.

The RFID labels 3, 4, 5, 6, and 7 according to the first modification to the fifth modification are illustrated as modifications based on the RFID label 2 according to the second embodiment, but these modifications may not include the third adhesive layer 24.

The present application claims priority under Japanese Patent Application No. 2022-178285 filed to the Japan Patent Office on November 7, 2022, and the entire content of this application is incorporated herein by reference.

## Claims

1. An RFID label comprising:
a heat-resistant substrate that is formed in a band shape, has a first portion and a second portion divided by a base point portion intersecting a longitudinal direction and extending in a width direction, and has heat resistance;
an antenna and an IC chip connected to the antenna that are provided in the second portion;
a first adhesive layer provided on the second portion; and
a second adhesive layer provided on the first portion to be attached to an adherend and having heat resistance, wherein
a length of the second portion in the longitudinal direction is formed to be larger than a length of the first portion in the longitudinal direction.

2. The RFID label according to claim 1, wherein
the first adhesive layer is disposed on a first surface of the heat-resistant substrate on an end portion side of the second portion opposite to the base point portion, and
the second adhesive layer is disposed on at least a part of a second surface opposite to the first surface.

3. The RFID label according to claim 2, wherein
the heat-resistant substrate has, at positions corresponding to a boundary portion on a base point portion side of the first adhesive layer, a pair of notches formed at both side edge portions extending in the longitudinal direction of the heat-resistant substrate.

4. The RFID label according to claim 2, wherein
the heat-resistant substrate has, at a position corresponding to a boundary portion on a base point portion side of the first adhesive layer, a perforation formed over both side edge portions extending in the longitudinal direction of the heat-resistant substrate.

5. The RFID label according to claim 2, further comprising:
a third adhesive layer disposed on the first surface of the heat-resistant substrate from the base point portion toward an inner side of the second portion.

6. The RFID label according to claim 5, wherein
the heat-resistant substrate has, at positions corresponding to a boundary portion opposite to the base point portion of the third adhesive layer, a pair of notches formed at both side edge portions extending in the longitudinal direction of the heat-resistant substrate.

7. The RFID label according to claim 5, wherein
the heat-resistant substrate has, at a position corresponding to a boundary portion opposite to the base point portion of the third adhesive layer, a perforation formed over both side edge portions extending in the longitudinal direction of the heat-resistant substrate.

8. The RFID label according to claim 1, wherein
the antenna and the IC chip are formed on a first surface of the heat-resistant substrate at the second portion.

9. The RFID label according to claim 1, wherein
the antenna and the IC chip are formed on a second surface of the heat-resistant substrate at the second portion.

10. The RFID label according to claim 1, wherein
the antenna and the IC chip are provided on an inlay substrate, and
the inlay substrate is disposed on a first surface of the heat-resistant substrate at the second portion.

11. The RFID label according to claim 1, wherein
the antenna and the IC chip are provided on an inlay substrate, and
the inlay substrate is disposed on a second surface of the heat-resistant substrate at the second portion.

12. The RFID label according to claim 1, wherein
the first adhesive layer has heat resistance.

13. A method for using an RFID label, the RFID label including
a heat-resistant substrate that is formed in a band shape, has a first portion and a second portion divided by a base point portion intersecting a longitudinal direction and extending in a width direction, and has heat resistance,
an antenna and an IC chip connected to the antenna that are provided in the second portion,
a first adhesive layer provided on the second portion, and
a second adhesive layer provided on the first portion to be attached to an adherend and having heat resistance,
a length of the second portion in the longitudinal direction being larger than a length of the first portion in the longitudinal direction,
the method comprising: folding at the base point portion, overlapping an end portion of the second portion and an end portion of the first portion, and bonding the second portion and the first portion by using the first adhesive layer.

14. A method for using an RFID label, the RFID label including
a heat-resistant substrate that is formed in a band shape, has a first portion and a second portion divided by a base point portion intersecting a longitudinal direction and extending in a width direction, and has heat resistance,
an antenna and an IC chip connected to the antenna that are provided in the second portion,
a first adhesive layer provided on the second portion, and
a second adhesive layer provided on the first portion to be attached to an adherend and having heat resistance,
a length of the second portion in the longitudinal direction being larger than a length of the first portion in the longitudinal direction,
the method comprising: folding at the base point portion, and attaching the first adhesive layer provided on the second portion and the second adhesive layer provided on the first portion to the same plane of the adherend in the vicinity of an end portion of the first portion.
